# EUROPÄISCHE PATENTSCHRIFT

(11) **EP 2 878 004 B1**
(45) Veröffentlichungstag und Bekanntmachung des Hinweises auf die Patenterteilung: **26.10.2022**
(21) Anmeldenummer: 13737282.7
(22) Anmeldetag: 17.07.2013
(51) Int. Cl.: H01J 37/244

(54) **MEHRFACHMODUL-PHOTONENDETEKTOR UND SEINE VERWENDUNG**
MULTI-MODULE PHOTON DETECTOR AND USE THEREOF
DÉTECTEUR PHOTONIQUE À PLUSIEURS MODULES ET UTILISATION DUDIT DÉTECTEUR

(30) Priorität: 26.07.2012 DE 102012213130
(43) Veröffentlichungstag der Anmeldung: 03.06.2015
(73) Patentinhaber: Bruker Nano GmbH, 12489 Berlin (DE)
(72) Erfinder: FALKE, Meiken, 09387 Jahnsdorf (DE); HAHN, Waldemar, 12435 Berlin (DE)
(74) Vertreter: Gulde & Partner
(86) Internationale Anmeldenummer: PCT/EP2013/065092
(87) Internationale Veröffentlichungsnummer: WO 2014/016180

(56) Entgegenhaltungen:
- DE-A1-102010 056 321
- DE-B3-102008 028 487
- JP-A- H08 222 172
- Anonymous: "Kapitell - Wikipedia", , 8 July 2012 (2012-07-08), XP055826877, Retrieved from the Internet: URL:https://de.wikipedia.org/w/index.php?t itle=Kapitell&oldid=105328300 [retrieved on 2021-07-22]

## Beschreibung

Die Erfindung betrifft einen Photonendetektor, insbesondere Röntgendetektor, sowie seine Verwendung für die energiedispersive Röntgendetektion in einem Elektronenmikroskop.

Die Elektronenmikroskopie, bei der eine Probe mit einem Elektronenstrahl abgetastet wird, dient zur abbildenden und spektroskopischen Materialanalytik von Strukturen im sichtbaren Bereich bis zu Strukturgrößen auf atomarer Ebene. Eine der Methoden, das Probenmaterial bezüglich seiner einzelnen Elemente des Periodensystems zu analysieren, ist die Detektion der Photonen, die bei der Elektronenmikroskopie im untersuchten Material durch die Elektronen generiert werden. Die Energie beziehungsweise Wellenlänge dieser Photonen ist spezifisch für das Element, in welchem sie generiert wurden, und liegt im Bereich der Röntgenstrahlung. Diese als Elektronenstrahlmikroanalyse bezeichnete Methode ist zwischenzeitlich zu einer routinemäßig angewendeten Methode entwickelt.

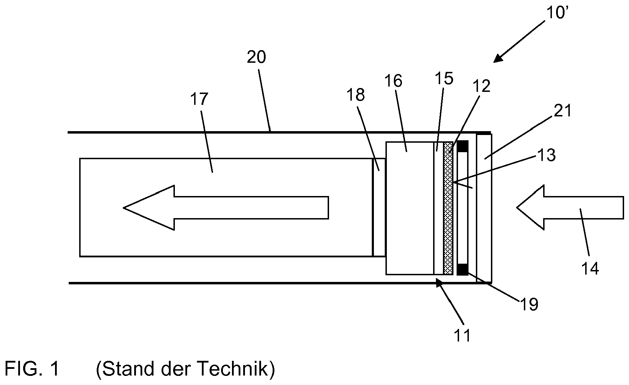

Der entscheidende Schritt zur Verbreitung der Elektronenstrahlmikroanalyse war die Einführung von energiedispersiven Röntgendetektoren (EDX-Detektoren), die sich durch ihre einfache und robuste Bauweise, Wartungsarmut, stabile Arbeitsweise und nicht zuletzt den relativ großen erfassten Raumwinkel (engl. solid angle) auszeichnen. EDX-Detektoren 10' - wie in Figur 1 dargestellt - verfügen üblicherweise (entsprech- end der Richtung der einfallenden Strahlung 14 über einen aktiven Sensorchip 12 aus einem Halbleiterkristall mit einer strahlungsexponierten Stirnfläche 13, eine mit dem Sensorchip verbundene Leiterplatte 15, eine aktive oder passive Kühleinrichtung 16 sowie eine Einrichtung zur Wärmeableitung 17. Das Gefüge aus Sensorchip 12, Leiterplatte 15 und Kühleinrichtung 16 bildet den Sensorkopf 11, welcher über eine Lotverbindung 18 mit der Einrichtung zur Wärmeableitung 17 verlötet ist. Auch lotfreie, dann meist Schraub-, Kleb- oder Steckverbindungen sind bekannt. Häufig weisen Röntgendetektoren noch einen Kollimator 19 zur Abschirmung von Sekundärröntgenstrahlung auf. Optional kann der Detektor 10' als geschlossenes System ausgebildet sein, wobei er eine Hülle 20 sowie ein vor dem Sensorchip 12 angeordnetes Eingangsfenster 21 aufweist.

Die Entwicklung von Elektronenmikroskopen zu immer besserer Auflösung, die Verbesserung der Elektronendetektoren, aber auch das vermehrte Interesse an organischen oder anderweitig empfindlichen Proben, haben den üblichen Strahlstrom soweit sinken lassen, dass in vielen Fällen auch mit EDX-Detektoren deutliche Grenzen gesetzt sind. Je kleiner der bestrahlte Strukturbereich des Probenmaterials, umso weniger Photonen werden unter sonst gleichen Bedingungen generiert. Der erfassbare Raumwinkel zur Detektion der Photonen muss deshalb so groß wie möglich sein, um bei vertretbaren Messzeiten eine möglichst große Photonenmenge zu detektieren. Um den Raumwinkel zu vergrößern, wird daher ein möglichst geringer Abstand zwischen der Probe und Detektor von wenigen Millimetern angestrebt. Dies ist ein Problem, da in den verfügbaren Elektronenmikroskopen rings um die untersuchte Probe üblicherweise wenig Platz zur Verfügung steht.

Besonders deutlich wird das Problem bei sogenannten SDD-Detektoren (Siliziumdriftdetektor, silicon drift detector), die von ihrer physikalischen Wirkungsweise und Bauart her ein Vielfaches der üblichen Strahlungsmenge erfassen könnten. SDD-Detektoren umfassen speziell gestaltete, starre Silizium-Chips, im Folgenden Detektor- oder Sensorchip genannt (E. Gatti & P. Rehak: Nuclear Instruments and Methods in Physics Research 225:608-614 , (1984); L. Strüder et al.: Microscopy and Microanalytics 4, 622-631, (1999)). Bei proben- oder gerätebedingter Begrenzung des Strahlstroms besteht der einzige Weg, die erfasste Strahlungsmenge zu vergrößern und damit die Messzeit zu verringern, darin, den vom Detektor erfassten Raumwinkel der Strahlung zu erhöhen. Zu diesem Zweck ist ein möglichst geringer Abstand des Detektors zu der Probe wünschenswert.

Aus DE 10 2008 014 578 A ist eine klein dimensionierte Magnetfalle für Röntgendetektoren zum Abfangen von Streuelektronen bekannt, die eine Verkleinerung des Detektors erlaubt.

DE 10 2009 026 946 A beschreibt einen Sensorkopf für einen Röntgendetektor aus störungsarmen Materialien, wodurch eine größere Nähe zur Probe und damit ein größerer Raumwinkel möglich wird, ohne dass das Magnetfeld zur Fokussierung des Elektronenstrahls im Elektronenmikroskop gestört wird.

Um den erfassten Raumwinkel und somit die detektierte Photonenmenge zu vergrößern, ist ferner bekannt, mehrere vollwertige Einzeldetektoren von mehreren Seiten in den Polschuhbereich in Probennähe einzubringen (kommerziell von Fa. Bruker; D. B. Williams et al.: Journal of Electron Microscopy 51 (Supplement): S113-S126 (2002), JP 07-014538 A). Dieser Ansatz wird auch in US 8,080,791 B2 verfolgt, wobei hier die Detektorchips direkt in den Polschuhbereich des Elektronenmikroskops eingesetzt sind und die Signalverarbeitung teilweise innerhalb und teilweise außerhalb des Mikroskops in Einzelkomponenten angeordnet ist. Die Verwendung mehrerer Einzeldetektoren erfordert jedoch das Vorhandensein mehrerer freier Adapterports, durch die die Detektormessfinger in die Mikroskopsäule eingeführt werden müssen. Diese Voraussetzung ist oft nicht oder nur für höchstens zwei oder drei Ports erfüllt. Außerdem wächst der Platzbedarf außerhalb rings um die Mikroskopsäule mit jedem zusätzlich eingesetzten Messfinger. Das Einsetzen aktiver Detektorchips direkt in den Polschuhbereich, wie in US 8,080,791 B2, erfordert zudem einen komplexen und kostenintensiven Umbeziehungsweise Neubau des Mikroskops. Zudem liegt das nötige Knowhow für den Umbau des Polschuhbereichs nur bei dem Mikroskophersteller selbst, und nicht bei dem auf Photonendetektoren und Spektroskopie spezialisierten Detektorzulieferer.

DE 10 2010 056 321 A1 und JP H08-222172 schlagen jeweils Röntgendetektoren vor, die mehrere Messköpfe aufweisen, in denen jeweils ein strahlungsempfindliches Substrat angeordnet ist.

Ein anderer Ansatz zur Vergrößerung des Raumwinkels liegt in der Verwendung von Detektoren mit relativ großflächigen Sensorchips mit aktiven Flächen von beispielsweise etwa 100 mm² (Fa. Jeol). Große Einzeldetektorflächen haben jedoch den Nachteil, dass die Randbereiche der zur Probe gerichteten aktiven Detektorfläche weiter von der Photonenquelle entfernt sind als der zentrale Bereich. Dies führt zu Detektionsverlusten in den Randbereichen und zu Ungenauigkeiten bei der Effizienz und Energieauflösung, da verschiedene Strahleintrittswinkel und Probe-Sensorabstände über die große Detektorfläche verteilt wirken. Außerdem erfordern Detektorchipflächen oberhalb von etwa 60 mm² für den Betrieb mit hoher Qualität eine höhere Kühlleistung als kleine Detektorflächen (ca. ≤ 60 mm²), was höheren technischen Aufwand erfordert. Es versteht sich zudem, dass große Chipflächen einer probennahen Anordnung entgegenstehen und insbesondere nicht so nah an die Probe herangerückt werden können wie kleinere aktive Chipflächen. Daher ist der Raumwinkelgewinn für große Einzelchipflächen im Vergleich zu kleineren begrenzt.

Darüber hinaus stehen Mehrsegmentchips zur Verfügung, die mehrere aktive Segmente auf einem einzigen Detektorchip aufweisen, welche in Messfinger eingebaut werden können (H. Soltau et al.: Microsc. Microanal. 15 (Suppl. 2), (2009) Microscopy Society of America, 204-205). Die Einsatzmöglichkeiten dieses Chips sind jedoch begrenzt, da ihre Außendurchmesser den erforderlichen Messfingerdurchmesser bestimmen. Weiterhin erlaubt die Anordnung der aktiven Chipsegmente auf einer Ebene (der Silizium-Chip-Ebene) kaum geometrische Freiheiten. Es besteht auch das bereits beschriebene Problem, dass die Randbereiche der einzelnen Chip-Segmente andere geometrische Bedingungen für die Photonendetektion bieten als die Innenbereiche, was zu Ungenauigkeiten führt.

Es ist daher die Aufgabe der vorliegenden Erfindung, einen Detektor, insbesondere für die EDX-Analyse in Elektronenmikroskopen, vorzuschlagen, der zumindest einige der Probleme des Standes der Technik überwindet. Insbesondere soll der Detektor eine hohe Genauigkeit hinsichtlich der Energieauflösung aufweisen und idealerweise einen großen Raumwinkel bei kleiner und kompakter Bauweise erfassen.

Die Aufgabe wird durch einen Photonendetektor sowie seine Verwendungen mit den Merkmalen der unabhängigen Ansprüche gelöst. Weitere erfindungsgemäße Ausgestaltungen sind Gegenstand der Unteransprüche.

Der erfindungsgemäße Photonendetektor weist die Gestalt eines säulenförmigen kompakten Messfingers auf, welcher sich entlang einer Detektorachse längserstreckt. Der Photonendetektor umfasst ein Gehäuse, das sich entlang der Detektorachse längserstreckt und ein einziges vorderes Ende aufweist, und einen an einem ersten Ende des Messfingers in dem vorderen Ende des Gehäuses angeordneten Detektorkopf, sowie zumindest ein Fenster wie im unabhänigen Vorrichtungs-Anspruch 1 definiert. Der Detektorkopf umfasst eine Mehrzahl von zumindest zwei Detektormodulen. Jedes Detektormodul umfasst einen für Photonenstrahlung empfindlichen Sensorchip mit einer exponierten Stirnfläche, welche somit der zu detektierenden Strahlung ausgesetzt werden kann; eine Leiterplatte, die auf der von der Stirnfläche abgewandten Fläche des Sensorchips angeordnet ist und signalleitend mit dem Sensorchip verbunden ist, und ein Kühlelement gemäß der nachfolgenden Anspruch 1.

Die Detektormodule des Detektorkopfs sind in einer, orthogonal zur Detektorachse verlaufenden Ebene achsensymmetrisch bezüglich der Detektorachse um die Detektorachse herum angeordnet.

Erfindungsgemäß weist der Detektor somit statt eines einzigen Detektormoduls eine Mehrzahl von wenigstens zwei Detektormodulen beziehungsweise zwei Sensorchips auf, die in derselben, orthogonal zur Detektorachse orientierten Ebene, vorzugsweise im Wesentlichen kreisförmig, um die Detektorachse herum angeordnet sind. (Die Ebene, in der die Detektormodule angeordnet sind, verläuft also derart, dass die Detektorachse orthogonal auf der Ebene steht.) Aus dieser Anordnung ergeben sich verschiedene Vorteile. Zunächst wird bei einer Mehrzahl von relativ kleinen aktiven Flächen der Sensorchips der einzelnen Detektormodule die einfallende Photonenstrahlung hinsichtlich ihrer Einfallswinkel und Weglängen (Abstand zwischen Photonenquelle und Auftreffpunkt auf dem Chip) homogenisiert. Das heißt, die Unterschiede der Einfallswinkel und Weglängen zwischen Rand- und Zentralbereichen der einzelnen Sensorchips sind aufgrund der geringeren Chipgrößen kleiner verglichen mit einem einzigen, größeren Sensorchip. Hieraus ergibt sich eine höhere Energieauflösung der Photonenspektren und es werden Detektionsverluste in den Randbereichen sowie zu weit variierende Strahleintrittswinkel und daraus folgende Ungenauigkeiten bei Analyse und Quantifizierung vermieden. Darüber hinaus entsteht bei kleineren aktiven Flächen der Sensorchips eine geringere Wärmeentwicklung. Die dadurch erforderliche geringere Einzel-Kühlleistung führt zu einer besseren und homogeneren Kühlung gegenüber einem einzigen, relativ großen Sensorchip. Schließlich sind die Herstellungskosten für kleinere Sensorchips niedriger als für große.

Dabei wird im Rahmen der vorliegenden Erfindung unter "Messfinger" säulenartige kompakte Gestalt länglicher Ausdehnung verstanden, die mit ihrem ersten Ende in Richtung der zu detektierenden Photonenquelle ausgerichtet werden kann. Somit entspricht die "Sichtrichtung" des Detektors im Wesentlichen seiner Detektorachse. Eine Querschnittsfläche des Messfingers (quer zur Detektorachse) kann beliebig gewählt sein, beispielsweise rund, sodass der Messfinger eine im Wesentlichen zylindrische Gestalt aufweist, oder oval oder viereckig oder dergleichen. Der erfindungsgemäße Photonendetektor ist vorzugsweise als Röntgendetektor ausgebildet, wobei die Sensorchips für wenigstens einen Teilspektralbereich der Röntgenstrahlung empfindlich sind. Insbesondere handelt es sich um einen energiedispersiven Röntgendetektor (EDX-Detektor). Die Eignung zur Röntgendetektion schließt zudem nicht aus, dass der Detektor zusätzlich auch für Photonen aus anderen Spektralbereichen als den Röntgenspektralbereich empfindlich ist. Auch wenn die vorliegende Beschreibung sich teilweise speziell auf einen Röntgendetektor und Röntgenstrahlung bezieht, versteht es sich, dass sämtliche Ausführungen auch für Detektoren mit Empfindlichkeiten für andere Spektralbereiche gelten.

Die Detektormodule weisen eine achsensymmetrische Anordnung bezüglich der Detektorachse auf. Dabei wird im Rahmen der vorliegenden Erfindung unter "achsensymmetrischer Anordnung" verstanden, dass bei einer Rotation des Detektors um die Detektorachse bei diskreten Drehwinkeln die Detektormodule auf sich selbst abgebildet werden. Dies trifft insbesondere für Drehwinkel von 360°/n zu, wobei n die Anzahl der Detektormodule ist. Bei einer Anzahl von 2 Detektormodulen werden die Detektormodule bei jeweils einem Drehwinkel von 180° um die Detektorachse aufeinander abgebildet, bei 3 Detektormodulen bei einem Drehwinkel von 120°, bei 4 Detektormodulen einem Drehwinkel von 90°, bei 5 Detektormodulen einem Drehwinkel von 72°, bei 6 Detektormodulen einem Drehwinkel von 60°, bei 7 Detektormodulen einem Drehwinkel von ca. 52°, bei 8 Detektormodulen einem Drehwinkel von 45°, usw. Eine alternative Definition besteht in einer Anordnung der Detektormodule um die Detektorachse derart, dass diese eine Spiegelsymmetrie bezüglich mindestens einer Spiegelebene aufweisen, wobei die Spiegelebene in einer Ebene mit der Detektorachse liegt. Diese Anordnung von mehreren Detektormodulen erlaubt bei geeigneter Orientierung des Detektors in einem Transmissionselektronenmikroskop die Erfassung von Photonen von der Probenvorderseite und -rückseite (s. u.).

Nach einer besonders bevorzugten Ausgestaltung der Erfindung ist zumindest ein Teil der Sensorchips, vorzugsweise sämtliche Sensorchips, gegenüber der orthogonal zur Detektorachse verlaufenden Ebene geneigt angeordnet, insbesondere derart, dass diese Sensorchips einen Neigungswinkel von < 90° zwischen Stirnfläche des Sensorchips und Detektorachse in Sichtrichtung des Röntgendetektors aufweisen. Durch diese Ausgestaltung wird eine Vergrößerung der aktiven Fläche der Sensorchips und damit eine Vergrößerung des erfassten Raumwinkels erzielt. Ferner erlaubt die geneigte Anordnung der Chips eine weitere Verbesserung hinsichtlich eines einheitlichen Eintrittswinkels der erfassten Röntgenstrahlung über die gesamte aktive Detektoreinzelfläche, wodurch genauere Quantifizierungsergebnisse möglich werden. Vorzugsweise sind die Sensorchips mit einem Neigungswinkel zur der Detektorachse im Bereich von 10° bis < 90° geneigt angeordnet, insbesondere im Bereich von 20° bis < 80°, vorzugsweise im Bereich von 30° bis 60°, besonders bevorzugt von 45°. Dabei müssen nicht sämtliche Sensorchips mit dem gleichen Neigungswinkel angeordnet sein.

In besonders bevorzugter Ausgestaltung der Erfindung sind die Sensorchips so geneigt angeordnet, dass die Gesamtheit ihrer (an sich ebenen) Stirnflächen sich einer sphärischen oder paraboloiden Anordnung bzw. einem Ausschnitt einer solchen Anordnung annähert. Dann ist die näherungsweise sphärische oder paraboloide Fläche der Gesamtheit der Stirnflächen symmetrisch um die Detektorachse und - im eingebauten Zustand - somit symmetrisch um eine näherungsweise punktförmige Strahlungsquelle ausgerichtet. Auf diese Weise wird der erfasste Raumwinkel noch weiter vergrößert.

Die Anzahl der Detektormodule kann beliebig gewählt sein, z.B. 2, 3, 4, 5, 6, 7, 8, 9, 10, 11, 12 oder mehr). Vorzugsweise beträgt sie 2 bis 12, insbesondere 2 bis 8, besonders bevorzugt 2 bis 4.

Die Detektormodule umfassen ferner jeweils eine Leiterplatte, welche auf der von der Stirnfläche abgewandten Fläche des Sensorchips angeordnet ist und signalleitend mit dem Sensorchip verbunden ist. Die Leiterplatten weisen jeweils Leiterbahnen auf, die auf einer Basisplatte, beispielsweise auf einer Keramik oder einem Kunststoff oder einem Verbundwerkstoff, aufgebracht ist.

Üblicherweise umfassen Photonensensoren Kühlmittel zur aktiven (kälteerzeugenden) oder passiven (wärmeabführenden) Kühlung des Sensorchips. Im Rahmen der vorliegenden Erfindung umfassen die Detektormodule jeweils ein aktives Kühlelement, das insbesondere jeweils als ein thermoelektrisches Kühlelement (Peltier-Element) ausgebildet sein kann, so dass eine individuelle Kühlung jedes einzelnen Detektormoduls erfolgt. Hierdurch wird eine besonders gute Kühlleistung und somit eine besonders gute Energieauflösung erzielt. Alternativ umfassen die Detektormodule ferner jeweils einen wärmeleitenden Sockel, wobei die wärmeleitenden Sockel der Detektormodule mit einer gemeinsamen Einrichtung zur Wärmeableitung des Detektors in thermischen Kontakt stehen (passive Kühlung). Gemäß einer alternativen Ausgestaltung umfassen die Detektormodule ferner jeweils einen wärmeleitenden Sockel, wobei die wärmeleitenden Sockel der Detektormodule mit einem gemeinsamen aktiven Kühlelement des Detektors in thermischen Kontakt stehen. Es versteht sich, dass sämtliche vorgenannten Kühlmittel, ob aktiv oder passiv, auf der von der exponierten Stirnfläche des Sensorchips abgewandten Fläche beziehungsweise der von dem Sensorchip abgewandten Seite der Leiterplatte angeordnet sind. Das heißt, sie sind bezüglich einer Einfallrichtung der Strahlung den Sensorchips beziehungsweise den Leiterplatten nachgeschaltet. (Im Rahmen der vorliegenden Beschreibung beziehen sich die Begriffe "vorgeschaltet" und "nachgeschaltet" grundsätzlich jeweils auf die Einfallsrichtung eines zu detektierenden Photonenstroms.)

Nach einer weiteren Ausgestaltung kann ein zusätzliches (gemeinsames) aktives Kühlelement den vorgenannten Kühlmitteln bezüglich der Strahlungseinfallrichtung nachgeschaltet sein, das heißt an eine weiter hinten im Messfinger gelegenen Position angeordnet sein. Diese Möglichkeit kann mit jeder der drei vorgenannten Alternativen der Kühlmittel kombiniert werden. Bei der bevorzugten modulindividuellen aktiven Kühlung ergibt sich somit eine doppelte aktive Kühlung.

Sowohl im Falle eines gemeinsamen aktiven Kühlelements als auch im Falle modulindividueller aktiver Kühlelemente sowie bei Verwendung beider Varianten gleichzeitig, ist das Kühlelement beziehungsweise sind die Kühlelemente bevorzugt jeweils als thermoelektrisches Kühlelement (Peltier-Element) ausgebildet. Diese haben den Vorteil geringer Größen und einfacher Steuerung über den Stromfluss. Der oder die wärmeleitenden Sockel zur passiven Kühlung umfassen ein wärmeleitendes Material, das heißt ein Material mit einer relativ hohen spezifischen Wärmeleitfähigkeit, beispielsweise Kupfer.

Vorzugsweise umfassen die Detektormodule ferner jeweils einen auf der Stirnfläche des Sensorchips angeordneten Kollimator, welcher die Aufgabe hat, Sekundärröntgenstrahlung abzuschirmen, die von den Primärphotonen der untersuchten Probe bei Auftreffen auf andere Bauteile induziert wird. Bei dem Kollimator handelt es sich im Wesentlichen um einen geometrischen Filter mit Blendenfunktion. Alternativ zu modulindividuellen Kollimatoren kann der Detektor jedoch auch einen einzigen Kollimator aufweisen.

Darüber hinaus kann der Röntgendetektor, insbesondere im Falle seiner Verwendung im Zusammenhang mit einem Rasterelektronenmikroskop, auch eine magnetische Elektronenfalle aufweisen, welche Streuelektronen abfängt. Die Elektronenfalle ist auf oder vor den Stirnflächen der Sensorchips angeordnet. Mit Vorteil kann die Elektronenfalle gemäß DE 10 2008 014 578 A ausgebildet sein.

Die Stirnflächen (aktive Flächen) der Sensorchips können gleich oder unterschiedlich groß sein. Insbesondere weisen die Sensorchips unabhängig voneinander eine Stirnfläche im Bereich von 2 mm² bis 100 mm² auf, vorzugsweise im Bereich von 10 mm² bis 80 mm², besonders bevorzugt im Bereich von 20 mm² bis 50 mm². Vorzugsweise weisen die einzelnen Sensorchips gleich große Stirnflächen auf.

Ebenso können die Konturen der Stirnflächen der Sensorchips gleich oder unterschiedlich sein, vorzugsweise sind sie gleich gewählt. Die Kontur richtet sich in erster Linie nach der Anzahl der Detektormodule sowie der Außengestalt des Messfingers und ist dabei vorzugsweise so gewählt, dass die verfügbare "Sichtfläche" des Detektors möglichst vollflächig genutzt wird. Beispielsweise können die Sensorchips unabhängig voneinander eine runde, ovale, dreieckige, viereckige, sechseckige, kreissektorförmige oder kreissegmentförmige Kontur aufweisen. Bei Konturen mit eckigen Elementen können diese auch abgerundet sein, sodass beispielsweise auch eine tropfenförmige Kontur (abgerundete kreissektorförmige Kontur) in Frage kommt.

Nach einer weiteren vorteilhaften Ausgestaltung umfassen die Detektormodule ferner jeweils einen, dem Sensorchip vorgeschalteten (modulindividuellen) Kollimator. Alternativ umfasst der Photonendetektor einen gemeinsamen, sämtlichen Detektormodulen vorgeschalteten Kollimator. Nach einer weiteren Alternative umfasst der Detektor mindestens einen, einer Untergruppe von Detektormodulen gemeinsam vorgeschalteten Kollimator.

Darüber hinaus ist der Detektor auch als geschlossenes System ausgebildet und weist ein Gehäuse (Hülle) sowie ein oder mehrere Fenster aus strahlungsdurchlässigem Material, insbesondere für Röntgenstrahlung, auf. Durch diese Ausbildung werden die Sensorchips geschützt. Auch hier kommen die im Zusammenhang mit dem Kollimator genannten alternativen Ausgestaltungen zum tragen. Somit können die Detektormodule ferner jeweils ein, dem Sensorchip vorgeschaltetes (modulindividuelles) Fenster umfassen. Alternativ können sämtliche Detektormodule durch ein einziges gemeinsames Fenster oder Gruppen von Einzelmodulen jeweils durch ein separates Fenster individuell geschützt sein.

Sofern der Detektor einen oder mehrere Kollimatoren aufweist, ist der beziehungsweise sind die Kollimator/en vorzugsweise dem/den Fenster/n vorgeschaltet. Hier ist der Kollimator somit außen angeordnet.

Die Sensorchips sind vorzugsweise als Siliziumdriftdetektoren (SDD) ausgebildet.

Ein weiterer Aspekt der Erfindung betrifft die Verwendung des erfindungsgemäßen Röntgendetektors für die energiedisperse Röntgendetektion (EDX) in einem Elektronenmikroskop (Rasterelektronenmikroskop (REM) oder Transmissionselektronenmikroskop (TEM).

In einer bevorzugten Ausgestaltung, insbesondere im Falle eines Röntgendetektors mit geneigt angeordneten Sensorchips, kann dieser in einem TEM so angeordnet werden, dass seine Detektorachse im Wesentlichen in Probenebene liegt. Auf diese Weise kann sowohl die von der mit dem Elektronenstrahl bestrahlten Probenvorderseite ausgehende Röntgenstrahlung detektiert werden, als auch die von der rückwärtigen Probenseite ausgehende Strahlung.

Die Erfindung wird nachfolgend anhand von Ausführungsbeispielen und den dazugehörigen Zeichnungen näher erläutert. Es zeigen:
- Fig. 1: einen Röntgendetektor gemäß Stand der Technik in einer Schnittansicht;
- Fig. 2: einen erfindungsgemäßen Röntgendetektor nach einer ersten Ausgestaltung in einer Schnittansicht;
- Fig. 3: eine Anordnung eines Röntgendetektors nach Figur 2 in einem Rast]erelektronenmikroskop (REM);
- Fig. 4: einen erfindungsgemäßen Röntgendetektor nach einer zweiten Ausgestaltung in einer Schnittansicht;
- Fig. 5: eine Anordnung eines Röntgendetektors nach Figur 4 in einem Transmissionselektronenmikroskop (TEM) und
- Fig. 6: ein Beispiel eines Photonenspektrums, aufgenommen mit einer Anordnung gemäß Figur 5.

Die nachfolgende Beschreibung bezieht sich auf einen Röntgendetektor, speziell einen energiedispersiven Röntgendetektor (EDX-Detektor). Es versteht sich jedoch, dass sämtliche Ausführungen auch für Detektoren mit Empfindlichkeiten für andere Spektralbereiche gelten.

Der prinzipielle Aufbau eines Röntgendetektors 10' gemäß Stand der Technik nach Figur 1 wurde bereits einleitend vorgestellt.

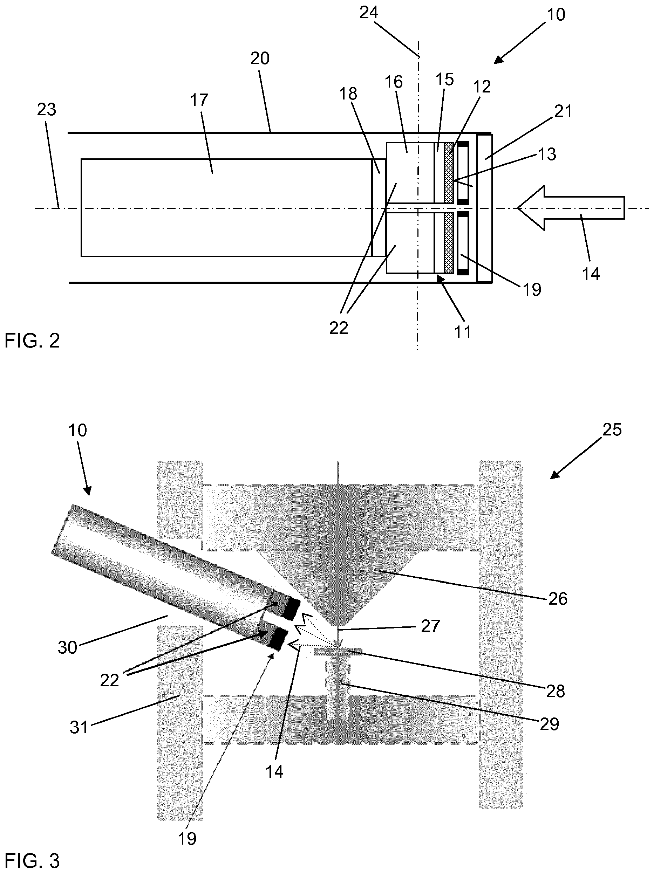

Figur 2 zeigt einen Röntgendetektor 10 gemäß einer ersten Ausgestaltung der vorliegenden Erfindung.

Kernelement des Detektors 10 ist ein Sensorkopf 11, der an einem vorderen Ende des Detektors angeordnet ist. Der Sensorkopf 11 weist erfindungsgemäß eine Mehrzahl von Detektormodulen 22 auf, hier beispielsweise vier Detektormodule 22, von denen in der gewählten Darstellung nur zwei sichtbar sind. Jedes einzelne Detektormodul 22 umfasst einen Sensorchip 12, bei dem es sich um ein röntgensensitives Halbleiterelement handelt und welches vorzugsweise als Silciumdriftdetektor (silicon drift detector, SSD) ausgebildet ist. Die Stirnflächen 13 (auch aktive Flächen genannt) der Sensorchips 12 sind freiliegend, so dass sie einer mit 14 angedeuteten Photonenstrahlung, insbesondere Röntgenstrahlung, ausgesetzt werden können. Die Detektormodule 22 umfassen ferner jeweils eine, an einer von der Stirnseite 13 des Sensorchips 12 abgewandten Seite angeordnete Leiterplatte 15 (printed circuit board), mit welcher der jeweilige Sensorchip 12 signalleitend verbunden ist. Die Leiterplatte weist Bondinseln auf, die über Bonddrähte mit Kontaktanschlüssen zur Weiterleitung der erfassten Signale verbunden sind (Bondinseln, Bonddrähte und Kontaktanschlüsse hier nicht dargestellt). Zum Zwecke der Miniaturisierung des Röntgendetektors können die Leiterplatten und das so genannte Bonding mit Vorteil entsprechend DE 10 2008 028 487 A ausgebildet sein. Vorzugsweise erfolgt das Bonding lediglich an zwei einander gegenüberliegenden Seiten der Leiterplatte.

Gemäß dem dargestellten Beispiel umfasst jedes Detektormodul 22 ferner ein Kühlelement 16 zur individuellen, aktiven Kühlung der Sensorchips 12, das auf der von dem Sensorchip 12 abgewandten Seite der Leiterplatte 15 angeordnet ist. Die Kühlelemente 16 sind bevorzugt als thermoelektrische Kühlelemente (Peltier-Elemente) ausgebildet. Der Sensorchip 12, die Leiterplatte 15 sowie das Kühlelement 16 können ferner auf einer nicht dargestellten Bodenplatte montiert sein.

Die den Sensorkopf 11 bildenden Module 22 sind insbesondere über ihren nicht dargestellten Sockel mit der Einrichtung zur Wärmeableitung 17 fest verschraubt, zusammengesteckt oder über eine Lotverbindung 18 verlötet. Die Einrichtung zur Wärmeableitung 17 umfasst ein wärmeleitendes Material, beispielsweise Kupfer, oder ist als so genannte Heat-Pipe ausgeführt und dient im Wesentlichen der Wärmeableitung (passives Kühlelement).

Vor dem Sensorchip 12 kann optional ein Kollimator 19 angeordnet sein, welcher Sekundärphotonen von dem Sensorchip 12 abhält. Optional kann zudem eine magnetische Elektronenfalle vor dem Sensorkopf 11 angeordnet sein, welche Streuelektronen des Elektronenmikroskops abhält. Die magnetische Elektronenfalle kann mit Vorteil gemäß DE 10 2008 014 578 A ausgebildet sein.

Der Röntgendetektor 10 ist erfindungsgemäß nicht als offenes System, sondern - wie dargestellt - als geschlossenes System ausgebildet, wobei die vorgenannten Komponenten durch ein Gehäuse 20 eingeschlossen sind, das an seinem vorderen Ende ein röntgendurchlässiges Fenster 21 aufweist. Die einzelnen Module können alternativ auch individuell durch ein Fenster geschützt sein.

In bevorzugter Ausgestaltung der Erfindung können die Materialien des Detektors 10 entsprechend DE 10 2009 026 946 A aus störungsarmen Materialien, insbesondere mit einer magnetischen Permeabilitätszahl µᵣ kleiner als 1,5 gewählt werden. Dies kann insbesondere die Materialien für Kontaktstifte, die Bodenplatte, das Gehäuse 20, das Fenster 21, verwendete Haft- und Sperrschichten sowie die Lotverbindung 18 betreffen. Geeignete Materialien sind in der vorgenannten Publikation genannt.

Darüber hinaus ist möglich, dass der Detektor ausgebildet ist, zusätzlich zu der Photonenstrahlung, insbesondere der Röntgenstrahlung, auch Elektronen detektieren zu können. Ein solcher Detektor ist in DE 10 2009 024 928 A beschrieben.

Der Detektor 10 weist die Gestalt eines Messfingers auf, welcher sich entlang einer Detektorachse 23 längserstreckt. Die Detektormodule 22 sind in einer Ebene 24 angeordnet, auf welcher die Detektorachse 23 orthogonal steht. Gemäß der gewählten Darstellung in Figur 2 verläuft die Ebene 24 senkrecht zur Papierebene. Erfindungsgemäß weisen die Detektormodule 22 eine achsensymmetrische Anordnung bezüglich der Detektorachse 23 auf. Demnach weisen sie zumindest eine Spiegelebene auf, in welcher die Achse 23 liegt, so dass die Detektormodule 22 bei Spiegelung an der Spiegelebene auf sich selbst abgebildet werden.

Im dargestellten Beispiel sind vier Sensorchips 12 mit jeweils einer (aus Sicht des Photonenstrahls 14) kreisförmigen Kontur quadratisch angeordnet. Andere Konturen sind im Rahmen der vorliegenden Erfindung jedoch ebenfalls verwendbar.

Zur weiteren Signalverarbeitung ist der Detektor 10 mit einer nicht dargestellten Verstärkereinheit ausgestattet oder mir einer solchen verbunden, die typischerweise einen Feldeffekt-Transistor (FET) und einen Vorverstärker aufweist. Die mit einem solchen Detektor erfassten Signale werden zur Weiterverarbeitung zu Photonenspektren in einem Spektrometer genutzt. Die Photonenspektren können im Elektronenmikroskop mit Elektronenstrahlrasterung ortsabhängig gemessen werden. Dies ermöglicht die abbildende, also ortsaufgelöste Elementanalytik.

Figur 3 zeigt eine beispielhafte Anordnung eines Detektors analog Figur 2 in einem Rasterelektronenmikroskop (REM) 25. Das REM 25 umfasst einen Polschuh 26, aus dem ein fokussierter Elektronenstrahl 27 austritt. Der Elektronenstrahl 27 trifft auf eine zu untersuchende Probe, welche auf einem Probenhalter 28 gehalten wird, welcher auf einem Probentisch 29 angeordnet ist. Der Elektronenstrahl 27 regt das Probenmaterial an, infolgedessen Röntgenstrahlung 14 von der Probe in alle Raumrichtungen emittiert wird. Ein Teil der Röntgenstrahlung 14 trifft auf den Röntgendetektor 10, welcher in einem Port 30 einer Mikroskopwand 31 des REM 25 installiert ist. Der Röntgendetektor 10 ist hier so angeordnet, dass sämtliche Sensorchips 12 der Detektormodule 22 der von dem Elektronenstrahl 27 bestrahlten Probenvorderseite zugewandt sind.

Es ist zu beachten, dass die Größe des Detektors 10 in Figur 3 bezüglich des Elektronenmikroskops 25 nicht maßstabsgetreu ist. Vielmehr ist der Detektor 10 übertrieben groß dargestellt. Ferner wurde in Figur 3 auf die Darstellung des Gehäuses 20 und des Fensters 21 verzichtet.

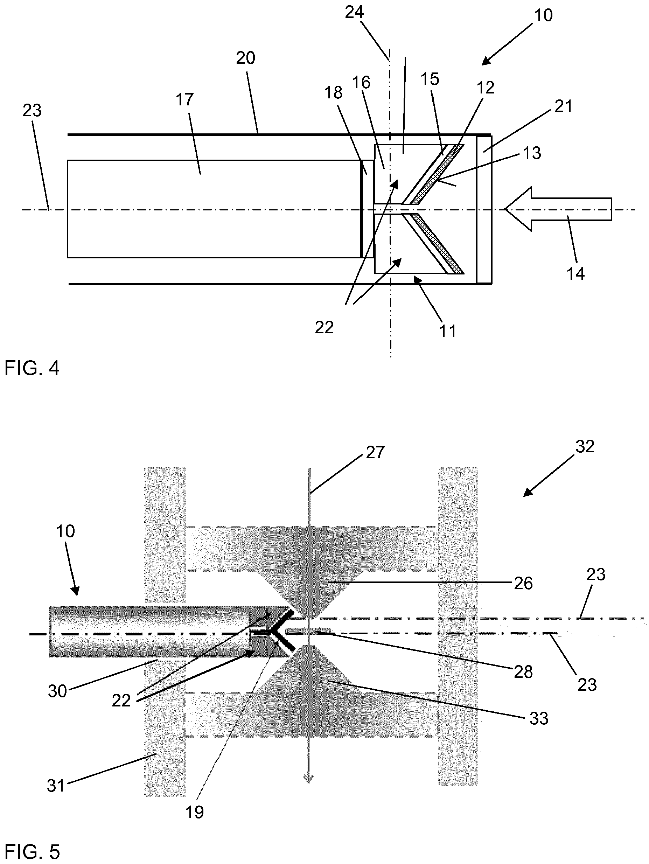

Figur 4 zeigt einen Röntgendetektor 10 gemäß einer weiteren Ausgestaltung der vorliegenden Erfindung. Übereinstimmende Elemente sind mit den gleichen Bezugszeichen wie in Figur 2 versehen und weisen - sofern nicht anders ausgeführt - die gleichen Eigenschaften wie diese auf.

Während die Sensorchips 12 des in Figur 2 dargestellten Röntgendetektors orthogonal zur Detektorachse 23 ausgerichtet sind, weisen die Sensorchips 12 des Röntgendetektors 10 nach Figur 4 eine geneigte Anordnung bezüglich der Detektorachse 23 beziehungsweise der Ebene 24 auf. Im dargestellten Beispiel beträgt der Neigungswinkel zwischen der Stirnfläche 13 der Sensorchips 12 und der Detektorachse 23 einheitlich 45°. Abweichend sind jedoch auch unterschiedliche Neigungswinkel der einzelnen Sensorchips 12 möglich oder die orthogonale Anordnung eines Teils der Sensorchips gemäß Figur 2 und die geneigte Anordnung des anderen Teils der Sensorchips gemäß Figur 4.

Vorzugsweise sind die Sensorchips 12 symmetrisch so um die Detektorachse 23 bzw. dem Röntgenstrahlung 14 angeordnet und geneigt, dass ihre einzelnen Stirnflächen 13 sich in ihrer Gesamtheit einem Sphäroid oder Paraboloid annähern.

In Figur 4 sind keine Kollimatoren dargestellt, können optional jedoch vorgesehen sein, entweder jeweils ein Kollimator pro Detektormodul 22 oder ein einziger gemeinsamer Kollimator oder als Kollimator beziehungsweise Kollimatoren für einige der Module.

Figur 5 zeigt die Anordnung des Sensors gemäß Figur 4 in einem Transmissionselektronenmikroskop (TEM) 32 (Größenverhältnisse wiederum nicht maßstabsgetreu). Anders als in Figur 4 ist vorliegend das Gehäuse 20 sowie das Fenster 21 des Detektors 10 nicht dargestellt, wohl jedoch zwei modulindividuelle Kollimatoren 19.

Das TEM 32 weist neben seinem oberen Polschuh 26 einen unteren Polschuh 33 auf, wobei der Probenhalter 28 zwischen beiden Polschuhen 26 und 33 angeordnet ist. Der durch die Probe hindurch tretende Elektronenstrahl 27 tritt durch den unteren Polschuh 33 zur weiteren elektronenmikroskopischen Analyse aus.

Der Röntgendetektor 10 ist gemäß Figur 5 derart in dem TEM 32 angeordnet, dass seine Detektorachse 23 im Wesentlichen in der Ebene der auf dem Probenhalter 28 gehaltenen Probe liegt. Auf diese Weise kann nicht nur die von der vom Elektronenstrahl 27 bestrahlten vorderen Probenseite ausgehende Röntgenstrahlung erfasst werden, sondern auch die von der rückwärtigen Probenseite ausgehende Röntgenstrahlung. Ein weiterer Vorteil dieser Anordnung besteht darin, dass in der Ebene der Probe, in welcher die nur durch Probenhalter und Proben-Bulkanteile veränderte und die Messung störende Röntgenstrahlung abgestrahlt wird, keine aktive Sensorfläche vorhanden ist. Vielmehr weist der Detektor 10 in dieser Ebene einen Spalt zwischen den Detektormodulen 22 auf. Aufgrund der auf diese Weise vermeidbaren störenden Strahlungsanteile auf den aktiven Sensorchipflächen wird ein verbessertes Signal-Rausch-Verhältnis erzielt.

Abweichend von der in Figur 5 dargestellten Anordnung kann der erfindungsgemäße Röntgendetektor 10 in einem Transmissionselektronenmikroskop auch so angeordnet werden, dass er ausschließlich auf der von dem Elektronenstrahl 27 zugewandten Probenseite oder ausschließlich auf der vom Elektronenstrahl 27 abgewandten Probenseite platziert ist.

Die erfindungsgemäße Ausgestaltung des Röntgendetektors mit mindestens zwei Detektormodulen 22 erlaubt verschiedene Vorgehensweisen hinsichtlich der Auslesung und Weiterverarbeitung der erfassten Signale. Gemäß einer ersten Option können die erfassten Signale sämtlicher Module 22 gemeinsam in Form von Mischsignalen ausgelesen werden. Alternativ können die erfassten Signale modulindividuell ausgelesen werden, wobei dies in zeitlicher Hinsicht gleichzeitig (parallel) oder nacheinander (sequentiell) erfolgen kann. Im Falle von mehr als zwei Detektormodulen 22 können die Signale einer beliebigen Kombination von zwei oder mehreren Modulen 22 gemeinsam in zusammengefasster Form ausgelesen werden, wobei auch dies in zeitlicher Hinsicht gleichzeitig (parallel) oder nacheinander (seriell) erfolgen kann.

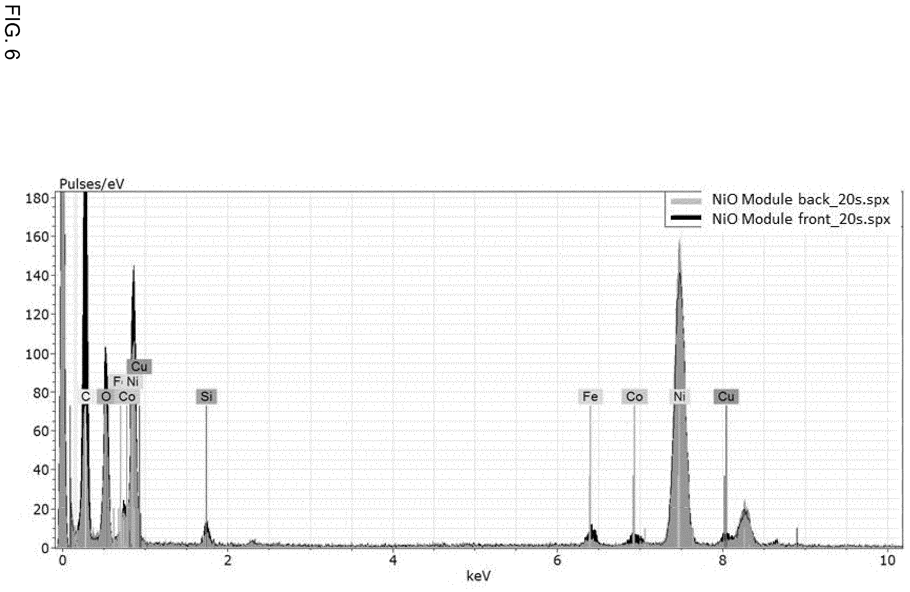

Der Detektor gemäß Figur 4 wurde in einem Transmissionselektronenmikroskop mit einer Anordnung gemäß Figur 5 getestet. Dabei wurden die erfassten Signale desjenigen Detektormoduls 22, das auf der dem Elektronenstrahl 27 zugewandten Probenseite angeordnet ist, separat von den Signalen des auf der vom Elektronenstrahl 27 abgewandten Probenseite angeordneten Moduls 22 ausgewertet. Figur 6 zeigt die auf diese Weise erhaltenen energiedispersiven Röntgenphotonenspektren. Dabei ist das auf der Probenvorderseite erfasste Röntgenspektrum schwarz dargestellt und das auf der Probenrückseite erfasste Spektrum grau.

Es ist erkennbar, dass insbesondere der im Niedrigenergiebereich erfasste Untergrund im Spektrum auf der Probenrückseite (grau) erwartungsgemäß größer ist als auf der Probenvorderseite (schwarz). Bei der Messung auf der dem Elektronenstrahl zugewandten Probenseite ist die Elementempfindlichkeit, das heißt das Peak-zu-Untergrundverhältnis insbesondere im Niedrigenergiebereich besser als auf der Probenrückseite. Außerdem erkennt man, dass auf der dem Elektronenstrahl zugewandten Probenseite mehr Streustrahlung durch Rückstreuelektronen, die den oberen Polschuh des Mikroskops treffen erfasst wird, was zum Auftreten von Peaks der Materialien Eisen (Fe) und Kobalt (Co) des Polschuhs führt.

### Bezugszeichenliste

- 10': Röntgendetektor gemäß Stand der Technik
- 10: Röntgendetektor gemäß Erfindung
- 11: Sensorkopf
- 12: Sensorchip
- 13: Stirnfläche
- 14: Photonenstrahl/Röntgenstrahl
- 15: Leiterplatte
- 16: Kühlelement
- 17: Einrichtung zur Wärmeableitung
- 18: Lotverbindung
- 19: Kollimator
- 20: Gehäuse
- 21: Fenster
- 22: Detektormodul
- 23: Detektorachse
- 24: Ebene
- 25: Rasterelektronenmikroskop
- 26: Polschuh
- 27: Elektronenstrahl
- 28: Probenhalter
- 29: Probentisch
- 30: Port
- 31: Mikroskopwand
- 32: Transmissionselektronenmikroskop
- 33: Polschuh
- 70: Probentisch
- 72: Röntgenstrahlung
- 74: Röntgendetektor

## Patentansprüche

1. Photonendetektor (10), der die Gestalt eines säulenförmigen kompakten Messfingers aufweist, welcher sich entlang einer Detektorachse (23) bis zu einem ersten Ende längserstreckt, umfassend
ein Gehäuse (20), das sich entlang der Detektorachse (23) längserstreckt und ein einziges vorderes Ende aufweist,
einen an dem ersten Ende des Messfingers in dem vorderen Ende des Gehäuses (20) angeordneten Detektorkopf (11), wobei der Detektorkopf (11) eine Mehrzahl von zumindest zwei Detektormodulen (22) umfasst, und
zumindest ein, den Detektormodulen (22) individuell oder gemeinsam vorgeschaltetes Fenster (21), das für Photonenstrahlung (14) durchlässig ist,
wobei jedes Detektormodul (22) jeweils umfasst:
einen für Photonenstrahlung (14) empfindlichen Sensorchip (12) mit einer exponierten Stirnfläche (13),
eine Leiterplatte (15), die auf der von der Stirnfläche (13) abgewandten Fläche des Sensorchips (12) angeordnet ist und signalleitend mit dem Sensorchip verbunden ist, und
ein aktives Kühlelement (16) oder einen wärmeleitenden Sockel, wobei die wärmeleitenden Sockel der Detektormodule (22) mit einer gemeinsamen Einrichtung zur Wärmeableitung (17) des Detektors (10) in thermischen Kontakt stehen,
wobei die Detektormodule (22) in einer, orthogonal zur Detektorachse (23) verlaufenden Ebene (24) achsensymmetrisch bezüglich der Detektorachse (23) um die Detektorachse (23) herum angeordnet sind.

2. Photonendetektor (10) nach Anspruch 1 oder 2, wobei zumindest ein Teil der Sensorchips (12) gegenüber der orthogonal zur Detektorachse (23) verlaufenden Ebene (24) geneigt angeordnet ist, insbesondere derart, dass diese Sensorchips (12) einen Neigungswinkel von < 90° zwischen Stirnfläche (13) des Sensorchips (12) und Detektorachse (23) in Sichtrichtung des Röntgendetektors (10) aufweisen.

3. Photonendetektor (10) nach Anspruch 2, wobei der Neigungswinkel der Sensorchips (12) gegenüber der Detektorachse (23) im Bereich von 10° bis < 90° liegt, insbesondere im Bereich von 20° bis < 80°, vorzugsweise im Bereich von 30° bis 60°, besonders bevorzugt von 45°.

4. Photonendetektor (10) nach einem der vorhergehenden Ansprüche, wobei die Anzahl der Detektormodule (22) 2 bis 12 beträgt, insbesondere 2 bis 8, vorzugsweise 2 bis 4.

5. Photonendetektor (10) nach einem der vorhergehenden Ansprüche, wobei die aktiven Kühlelemente (16) der Detektormodule (22) jeweils als ein thermoelektrisches Kühlelement ausgebildet sind.

6. Photonendetektor (10) nach einem der vorhergehenden Ansprüche, ferner umfassend zumindest einen, den Sensorchips (12) individuell oder gemeinsam vorgeschalteten Kollimator (19).

7. Photonendetektor (10) nach einem der vorhergehenden Ansprüche, wobei die Sensorchips (12) als Silizium-Drift-Detektoren (SDD) ausgebildet sind.

8. Photonendetektor (10) nach einem der vorhergehenden Ansprüche, wobei die Stirnflächen (13) der Sensorchips (12) unabhängig voneinander eine Fläche im Bereich von 2 mm² bis 100 mm², insbesondere im Bereich von 10 mm² bis 80 mm², im Bereich von 20 mm² bis 60 mm², aufweisen.

9. Photonendetektor (10) nach einem der vorhergehenden Ansprüche, wobei der Photonendetektor (10) ein Röntgendetektor ist und die Sensorchips (12) für Röntgenstrahlung empfindlich sind.

10. Verwendung eines Photonendetektor (10) nach einem der Ansprüche 1 bis 9 für die energiedisperse Röntgendetektion (EDX) in einem Elektronenmikroskop (25, 32).

11. Verwendung nach Anspruch 10, wobei das Elektronenmikroskop ein Transmissionselektronenmikroskop (32) ist und der Photonendetektor (10) mit seiner Detektorachse (23) im Wesentlichen in Probenebene angeordnet wird.

## Claims

1. A photon detector (10), having the form of a column-like compact measurement finger extending longitudinally along a detector axis (23) to a first end, comprising
a housing (20) extending longitudinally along the detector axis (23) and comprising a single front end,
a detector head (11) disposed at the first end of the measurement finger in the front end of the housing (20), wherein the detector head (11) comprises a plurality of at least two detector modules (22), and
at least one optical window (21) being individually or collectively arranged upstream of the detector modules (22), which is permeable for photon radiation (14),
each detector module (22) comprising respectively:
a sensor chip (12) sensitive to photon radiation (14) having an exposed end face (13),
a printed circuit board (15) arranged on the face of the sensor chip (12) facing away from the end face (13) and connected to the sensor chip in a signal-conducting manner, and
an active cooling element (16) or a heat-conducting base, wherein the heat-conducting base of the detector modules (22) being in thermal contact with a common means for heat removal (17) of the detector (10),
wherein the detector modules (22) are arranged in a plane (24) around the detector axis (23) in an axially symmetric arrangement with respect to the detector axis (23), the plane (24) extending orthogonally to the detector axis (23).

2. The photon detector (10) according to claim 1 or 2, wherein at least a part of the sensor chips (12) is arranged inclined with respect to the plane (24) extending orthogonally to the detector axis (23), in particular in a such a way that these sensor chips (12) have an angle of inclination of < 90° between the end face (13) of the sensor chip (12) and the detector axis (23) in the viewing direction of the X-ray detector (10).

3. The photon detector (10) according to claim 2, wherein the angle of inclination of the sensor chips (12) with respect to the detector axis (23) lies in the range from 10° to < 90°, in particular in the range from 20° to < 80°, preferably in the range from 30° to 60°, particularly preferably 45°.

4. The photon detector (10) according to any one of the preceding claims, wherein the number of detector modules (22) is 2 to 12, in particular 2 to 8, preferably 2 to 4.

5. The photon detector (10) according to any one of the preceding claims, wherein the active cooling elements (16) of the detector modules (22) are each formed as a thermoelectric cooling element.

6. The photon detector (10) according to any one of the preceding claims, further comprising at least one collimator (19) arranged individually or collectively upstream of the sensor chips (12).

7. The photon detector (10) according to any one of the preceding claims, wherein the sensor chips (12) are formed as silicon drift detectors (SDD).

8. The photon detector (10) according to any one of the preceding claims, wherein the end faces (13) of the sensor chips (12) independently of each other have an area within a range from 2 mm² to 100 mm², in particular in the range from 10 mm² to 80 mm², in the range from 20 mm² to 60 mm².

9. The photon detector (10) according to any one of the preceding claims, wherein the photon detector (10) is an X-ray detector and the sensor chips (12) are sensitive to X-rays.

10. Use of a photon detector (10) according to any one of claims 1 to 9 for energy dispersive X-ray (EDX) detection in an electron microscope (25, 32).

11. Use according to claim 10, wherein the electron microscope is a transmission electron microscope (32) and the photon detector (10) is arranged with its detector axis (23) substantially in the sample plane.

## Revendications

1. Un détecteur de photons (10) ayant la forme d'un doigt de mesure compact en forme de colonne qui s'étend longitudinalement le long d'un axe de détecteur (23) jusqu'à une première extrémité, comprenant
un boîtier (20) qui s'étend longitudinalement le long de l'axe du détecteur (23) et qui présente une seule extrémité avant,
une tête de détection (11) disposée à la première extrémité du doigt de mesure dans l'extrémité avant du boîtier (20), la tête de détection (11) comprenant une pluralité d'au moins deux modules de détection (22), et
au moins une fenêtre (21) placée en amont des modules de détection (22), individuellement ou en commun, qui est transparente pour le rayonnement photonique (14),
chaque module de détection (22) comprenant respectivement :
une puce de détection (12) sensible au rayonnement photonique (14) et présentant une face frontale exposée (13),
une carte de circuit imprimé (15) qui est disposée sur la surface de la puce de détection (12) opposée à la face frontale (13) et qui est reliée à la puce de détection de manière à conduire les signaux, et
un élément de refroidissement actif (16) ou un socle conducteur de chaleur, les socles conducteurs de chaleur des modules de détection (22) étant en contact thermique avec un dispositif commun de dissipation de chaleur (17) du détecteur (10),
dans lequel les modules de détecteur (22) étant disposés autour de l'axe de détecteur (23) dans un plan (24) orthogonal à l'axe de détecteur (23), avec une symétrie axiale par rapport à l'axe de détecteur (23).

2. Détecteur de photons (10) selon la revendication 1 ou 2, dans lequel au moins une partie des puces de détection (12) est disposée de manière inclinée par rapport au plan (24) orthogonal à l'axe du détecteur (23), en particulier de telle sorte que ces puces de détection (12) présentent un angle d'inclinaison < 90° entre la surface frontale (13) de la puce de détection (12) et l'axe du détecteur (23) dans la direction de visualisation du détecteur de rayons X (10).

3. Détecteur de photons (10) selon la revendication 2, dans lequel l'angle d'inclinaison des puces de capteur (12) par rapport à l'axe du détecteur (23) est compris entre 10° et < 90°, en particulier entre 20° et < 80°, de préférence entre 30° et 60°, de manière particulièrement préférée entre 45°.

4. Détecteur de photons (10) selon l'une des revendications précédentes, dans lequel le nombre de modules de détection (22) est de 2 à 12, en particulier de 2 à 8, de préférence de 2 à 4.

5. Détecteur de photons (10) selon l'une des revendications précédentes, dans lequel les éléments de refroidissement actifs (16) des modules de détection (22) sont chacun conçus comme un élément de refroidissement thermoélectrique.

6. Détecteur de photons (10) selon l'une des revendications précédentes, comprenant en outre au moins un collimateur (19) placé en amont des puces de détection (12), individuellement ou conjointement.

7. Détecteur de photons (10) selon l'une des revendications précédentes, dans lequel les puces de détection (12) sont des détecteurs de dérive au silicium (SDD).

8. Détecteur de photons (10) selon l'une des revendications précédentes, dans lequel les faces frontales (13) des puces de détection (12) présentent indépendamment les unes des autres une surface comprise entre 2 mm² et 100 mm², notamment entre 10 mm² et 80 mm², entre 20 mm² et 60 mm².

9. Détecteur de photons (10) selon l'une quelconque des revendications précédentes, dans lequel le détecteur de photons (10) est un détecteur de rayons X et les puces de détection (12) sont sensibles aux rayons X.

10. Utilisation d'un détecteur de photons (10) selon l'une des revendications 1 à 9 pour la détection de rayons X à énergie dispersée (EDX) dans un microscope à électrons (25, 32).

11. Utilisation selon la revendication 10, dans laquelle le microscope à électrons est un microscope électronique à transmission (32) et le détecteur de photons (10) est disposé avec son axe de détection (23) sensiblement dans le plan de l'échantillon.
